# EUROPEAN PATENT APPLICATION

(11) **EP 2 720 282 A1**
(43) Date of publication of application: **16.04.2014**
(21) Application number: 11865324.5
(22) Date of filing: 11.05.2011
(51) Int. Cl.: H01L 33/08, H01L 33/24

(54) **LED CHIP UNIT AND MANUFACTURING METHOD THEREOF, AND LED MODULE**

(71) Applicant: Sunsun Lighting China Co., Ltd, Jiangsu 210012 (CN)
(72) Inventor: SUN, Jianning, Shenzhen Guangdong 518000 (CN)
(74) Representative: Hörschler, Wolfram Johannes
(86) International application number: PCT/CN2011/073939
(87) International publication number: WO 2012/151748

(57) **Abstract**

Disclosed are a LED chip unit and manufacturing method thereof, a LED module, an illuminating device and a display device. The LED chip unit (1) comprises a plurality of LED cores (2) which are electrically isolated from each other. The LED chip unit (1) is used for a cutting unit of an epitaxial wafer (15), so that scraping channels between the LED chip units (1) are only reserved. The area which the space between the adjacent cores (2) occupies is less than the scraping channel, so that utilization ratio of the epitaxial wafer is increased. The cores are integrated and the LED chip unit (1) is packaged on the base plate as a basic unit, so that the cores (2) are packaged on the base plate at a time. This makes packaging more simply.

## Description

### Field of the Invention

The present invention pertains to the field of photoelectric technology, and in particular relates to a LED chip unit, a manufacturing method of the LED chip unit, a LED module, and a lighting apparatus and a display apparatus.

### Background of the Invention

As everyone knows, LEDs, as a new generation of green lighting sources, have numerous advantages such as high luminous efficiency, long service life, bright colors, power saving, and environmental friendliness, etc., and they are applied in more and more domains, such as indoor and outdoor lighting, back-light sources, display, medical treatment, transportation, and plant growing domains, etc.

A trend in the development of LED ICs and Solid State Lighting (SSL) technology is: the structural design of chips shall not only achieve high chip performance but also shall coincide with the structural design in the follow-up encapsulation procedure and the demand for the final application products. In the conventional LED encapsulation process, LEDs have to be connected to external circuits through gold wires. Gold wires have the following drawbacks: (1) they are one of the factors that result in degraded yield and reliability; (2) gold wire bonding pads and the wire size are too small; therefore, it is difficult to carry out aging treatment for the pads and wires separately; instead, aging usually has to be carried out after the LED chip is encapsulated; that approach brings an adverse factor to the encapsulated product, i.e., the chip performance can not be ascertained; as long as the chip in the encapsulated product is off-specification, the encapsulated product will be unacceptable; therefore, it is very important to carry out aging for the LED chip before encapsulation; (3) gold wires cause increased thickness of the encapsulated LED product, and hinder product development towards thin and light trend.

A general developing trend of LED encapsulation is: to reduce or eliminate the use of gold wires, and to develop towards thin, light and miniature direction.

To overcome the drawbacks of normal chips, Lumileds Lighting Company invented a flip-chip structure (Patent No.: EP1207563A2). In that structure, the light is extracted from the sapphire substrate rather than from the current diffusing layer. Since it is unnecessary to extract light from the current diffusing layer, the thickness of opaque current diffusing layer can be increased; thus, the current density of flip-chip can be increased. In addition, in that structure, the heat of PN junctions can be directly conducted to the silicon substrate that has a high thermal conductivity coefficient via metal bumps, and consequently the heat dissipation effect is better; moreover, a reflective layer is added between PN junction and P electrode; as a result, the light barrier phenomenon of the electrodes and lead wires is eliminated, and the electrical, optical, and thermal properties are improved with such a structure.

In the above-mentioned structure, though the LED chip is directly bonded to the electrodes on the substrate, the electrodes on the substrate are led out with gold wires. In the LED encapsulation structure described in patent document CN200910039786.7, through-holes are etched on the silicon substrate, and the electrodes on the substrate are led through the through-holes to the back of the silicon substrate. In such a LED encapsulation structure, bonded wires are eliminated completely, the reliability and thermal characteristics are further improved, and the encapsulation structure can be further miniaturized.

Up to now, for flip-chip bonding, a large number of patents have described the encapsulation structure and dipolar manufacturing methods for flip-chip bonding structure. Some commonly used methods for manufacturing and encapsulating bump LED usually comprise:
producing a passivation layer, producing a sacrificial metal layer by sputter coating,
producing a photoresist mask, forming metal bumps, removing the photoresist mask,
removing the sacrificial metal layer, thinning and cutting the wafer into separate chips, and
bonding the chips to a SMD lead-frame by flip-chip bonding, to form a flip-chip bonded LED module.

However, in the LED chip manufacturing process described above, the tube cores on the epitaxial wafer have to be cut apart. The footprint of the scribe lines is large and results in low utilization ratio of the epitaxial wafer owing to the limitation of the precision of laser scribing machine and the substrate material. In addition, the follow-up encapsulation process is complex and has low efficiency, because the LED tube cores have to be placed on the substrate one by one.

### Disclosure of the Invention

### Technical Problem

An object of the present invention is to provide a LED chip unit that contains a plurality of tube cores, so as to improve the utilization ratio of epitaxial wafer and simplify the follow-up encapsulation process.

Another object of the present invention is to provide a method for manufacturing the above-mentioned LED chip unit.

Another object of the present invention is to provide a LED module, which employs the above-mentioned LED chip units and a packaging substrate that bear the LED chip units.

Another object of the present invention is to provide a LED lighting apparatus, which has the above-mentioned LED module and a power supply unit that drives the LED module.

Another object of the present invention is to provide a LED display apparatus, which has the above-mentioned LED chip units.

### Technical Solution

An embodiment of the present invention is implemented as follows: a LED chip unit, comprising a plurality of LED tube cores electrically isolated from each other.

The present invention provides a method for manufacturing the above-mentioned LED chip unit, comprising the following steps:
forming a first semiconductor layer, a luminous layer, and a second semiconductor layer on a substrate in sequence, to produce an epitaxial wafer;
dividing the epitaxial wafer into a plurality of LED chip units, and electrically isolating the tube cores from each other in each LED chip unit;
producing electrodes for the LED chip units or connecting the electrodes among the LED tube cores at the same time, and performing cutting operation to obtain the LED chip units.

### Beneficial Effects

In the embodiment of the present invention, LED chip units that respectively contain a plurality of tube cores electrically isolated from each other are used as cutting units of an epitaxial wafer; thus, only scribe lines have to be reserved between the LED chip units, and the electrically isolating area between adjacent tube cores is smaller than the area of scribe line; therefore, the utilization ratio of the epitaxial wafer is greatly improved; since a plurality of tube cores are formed integrally, LED chip units are used as basic units and are encapsulated on the substrate in the follow-up encapsulation process; thus, a plurality of tube cores can be encapsulated on the substrate in one operation, and thereby the follow-up encapsulation process is greatly simplified.

### Brief Description of the Drawings

Figure 1 is a schematic structural diagram of the LED chip unit provided in an embodiment of the present invention;
Figure 2 is a schematic structural diagram of an epitaxial wafer to be cut in an embodiment of the present invention;
Figure 3 is an implementation flow chart of a method for manufacturing the above-mentioned LED chip unit provided in an embodiment of the present invention;
Figure 4 is a schematic structural diagram of an epitaxial wafer provided in an embodiment of the present invention;
Figure 5 is a schematic structural diagram of an epitaxial wafer provided in an embodiment of the present invention (after isolation trenches and scribe lines are formed);
Figure 6 is a schematic structural diagram of an epitaxial wafer provided in an embodiment of the present invention (after first semiconductor windows are formed).

### Detailed Description of the Embodiments

To make the objects, technical solution and advantages of the present invention be understood more clearly, hereunder the present invention will be further detailed in embodiments, with reference to the accompanying drawings. It should be appreciated that the embodiments described hereunder are only provided to interpret the present invention but do not constitute any limitation to the present invention.

In the embodiment of the present invention, LED chip units that respectively contain a plurality of tube cores electrically isolated from each other are used as cutting units of an epitaxial wafer; thus, only scribe lines have to be reserved between the LED chip units, and the electrically isolating area between adjacent tube cores is smaller than the area of scribe line; therefore, the utilization ratio of the epitaxial wafer is greatly improved; since a plurality of tube cores are formed integrally, LED chip units are used as basic units and are encapsulated on the substrate in the follow-up encapsulation process; thus, a plurality of tube cores can be encapsulated on the substrate in one operation, and thereby the follow-up encapsulation process is greatly simplified.

Hereunder the implementation of the present invention will be detailed in an example of a flip-chip bonded LED chip unit.

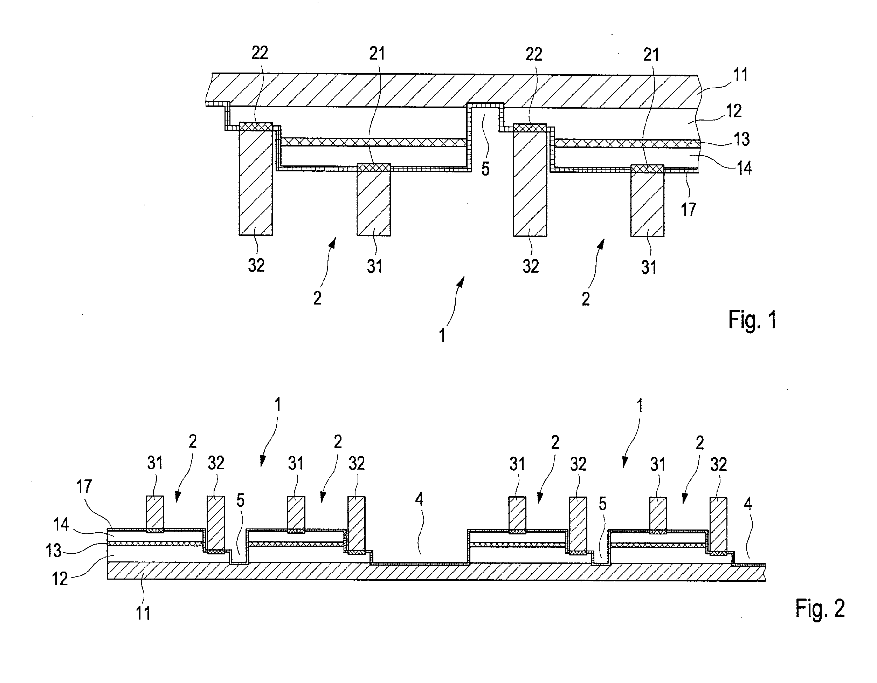

As shown in Figure 1 and Figure 2, the LED chip unit 1 provided in an embodiment of the present invention comprises a plurality of LED tube cores 2 that are electrically isolated from each other. Thus, the LED chip units 1 are used as the cutting unit of an epitaxial wafer 15, only a scribe line 4 has to be reserved between adjacent LED chip units 1, the electrically isolating area between adjacent LED tube cores 2 is smaller than the area of scribe line 4; therefore, the utilization ratio of the epitaxial wafer 15 is greatly improved; since a plurality of LED tube cores 2 are formed integrally, the LED chip units 1 are used as basic units in the follow-up encapsulation process; thus, the follow-up encapsulation process can be simplified greatly.

Usually, adjacent LED tube cores 2 are electrically isolated from each other by an isolation trench 5 with the bottom surface down to the substrate 11. The isolation trenches 5 are produced with integrated circuit (IC) technology, with a width not greater than 2µm, much narrower than the width of existing scribe lines (20∼100µm). In the embodiment of the present invention, matured integrated circuit (IC) technology is applied in the manufacturing process of the LED chip units, and the isolation trenches 5 formed with IC technology reach the precision of wafer-level encapsulation; thus, the utilization ratio of the epitaxial wafer 15 is further improved.

Of course, the electrodes of a plurality of tube cores 2 in LED chip unit 1 can be separated from each other, or can be connected in series and in parallel by means of conductive films, led out from pins, and then connected to the substrate circuit. Thus, the electrodes between the tube cores can be connected when the LED chip unit is manufactured, and thereby the follow-up encapsulation procedure can be further simplified.

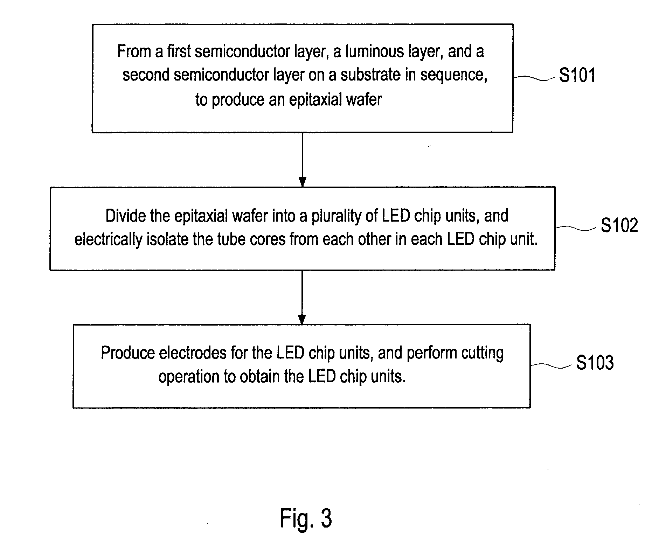

Figure 3 shows the implementation process of a method for manufacturing the above-mentioned LED chip unit provided in an embodiment of the present invention. The method will be detailed as follows:
In step S101, a first semiconductor layer, a luminous layer, and a second semiconductor layer are formed on a substrate in sequence, to produce an epitaxial wafer;

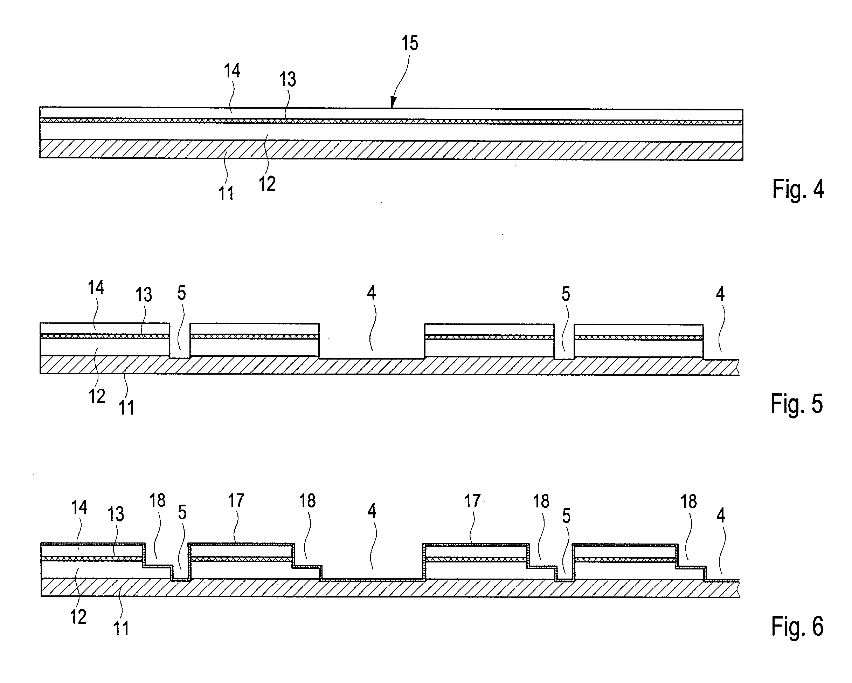

As shown in Figure 4, first, a first semiconductor layer 12 is grown on a substrate 11, then, a luminous layer 13 is deposited on the first semiconductor layer 12; next, a second semiconductor layer 14 is grown on the luminous layer 13; thus, an epitaxial wafer 15 is produced. Wherein, the material of the substrate 11 is preferably a heat conductive material, including, but not limited to sapphire, silicon, silicon carbide, or alloy.

Usually, the first semiconductor layer 12 is an N-type semiconductor layer (e.g., N-GaN), the second semiconductor layer 14 is a P-type semiconductor layer (e.g., P-GaN), and the luminous layer 13 can be (but not limited to) an energy gap layer or multiple quantum well (MQW).

In step S 102, the epitaxial wafer is divided into a plurality of LED chip units, and the tube cores in each LED chip unit are electrically isolated from each other;

As shown in Figure 5, the epitaxial wafer 15 is divided into a plurality of LED chip units 1, and each LED chip unit 1 contains two LED tube cores 2 that are electrically isolated from each other. Usually, an isolation trench 5 with the bottom surface down to the substrate 11 is formed between adjacent LED tube cores 2 in the LED chip unit 1 to isolate the LED tube cores 2 electrically from each other.

The isolation trenches 5 are formed by removing first semiconductor layer partly, luminous layer partly, second semiconductor layer partly, and substrate partly from the epitaxial wafer 15. Usually, the isolation trenches 5 are formed at the same time with the scribe lines 4 between the LED chip units 1. In the embodiment of the present invention, the isolation trenches 5 and scribe lines 4 are formed by removing first semiconductor layer partly, luminous layer partly, second semiconductor layer partly, and substrate partly from the epitaxial wafer 15 with IC technology.

Specifically, first, photoresist is coated on the second semiconductor layer 14, to form scribe windows at the scribe lines between adjacent LED chip units 1 and isolation windows at the isolation trenches between adjacent tube cores 2 in each LED chip unit 1. Then, the epitaxial layer (comprising a part of the first semiconductor layer, a part of the luminous layer, a part of the second semiconductor layer, and a part of the substrate) is removed at the scribe windows and isolation windows by dry etching or wet etching, to form scribe lines 4 and isolation trenches 5. Finally, the photoresist is removed, and the substrate is cleaned, and the next procedure is executed.

In step S 103, electrodes for the LED chip units are produced, and cutting operation is performed to obtain the LED chip units.

In the embodiment of the present invention, each tube core 2 in a LED chip unit 1 has a pair of electrodes. First, a passivation layer 17 is deposited on the second semiconductor layer 14, and the passivation layer 17 is also distributed on the scribe lines 4 and isolation trenches 5, so that the epitaxial layer, scribe lines 4, and isolation trenches 5 are protected by the passivation layer 17.

Next, first semiconductor windows 18 are produced by etching, and the windows 18 are passivated again, as shown in Figure 6.

Then, the passivation layer is removed at the electrodes on the first semiconductor layer and the electrodes on the second semiconductor layer, to form first electrode pores and second electrode pores respectively. A metal film is coated by vaporization in the first electrode pores and the second electrode pores respectively, to form first electrodes 21 (P electrodes) and second electrodes 22 (N electrodes); next, first pins 31 and second pins 32 for electrically connecting to the substrate circuit are grown on the first electrodes 21 and the second electrodes 22; finally, the epitaxial wafer is cut along the cutting line (i.e., scribe line 4), to obtain LED chip units 1.

In another embodiment of the present invention, the electrodes between the LED tube cores are connected by means of conductive films when the LED chip units are manufactured. First, a protective insulating layer (i.e., protective layer, such as a SiO₂ layer or Si₃N₄ layer) is grown on the second semiconductor layer, and the protective layer is also distributed on the above-mentioned scribe lines 4 and isolation trenches 5, so that the epitaxial layer, scribe lines 4, and isolation trenches 5 are protected by the protective layer. Next, first semiconductor windows 18 are produced by etching, and the windows 18 are protected again by the protective layer.

Then, trenches that separate each LED chip unit into P-region and N-region are produced on the protective layer through a photolithographic process, and a transparent conductive film is grown in the P-region and N-region respectively. Likewise, transparent conductive films that are designed to connect the P electrode and N electrode of the adjacent tube cores in series and in parallel are grown in the isolation trenches.

Then, the protective layer is removed at the electrodes on the first semiconductor layer and the electrodes on the second semiconductor layer, to form first electrode pores and second electrode pores. A metal film is coated by vaporization in the first electrode pores and second electrode pores respectively, to form first electrodes (P electrodes) and second electrodes (N electrodes); next, first pins and second pins for electrically connecting to the substrate circuit are grown on the first electrodes and the second electrodes.

Finally, the epitaxial wafer is cut along the cutting line (i.e., scribe line), to obtain LED chip units.

The pattern of the above-mentioned electrodes is preferably an umbrella pattern or a grid pattern, to provide better current density and to reduce heat and optical loss.

The LED module provided in an embodiment of the present invention comprises the above-mentioned LED chip units and a packaging substrate that bears the LED chip units, wherein, the packaging substrate has the same circuit pattern as the circuit connections of the tube cores in the LED chip units. The packaging substrate can be a metal substrate, a silicon substrate, or a ceramic substrate. A silicon substrate is preferred for wafer-level encapsulation. The packaging substrate is manufactured mainly by disposing a metal pattern that matches the pins of the LED chip units on the substrate and ensuring that the metal pattern has high thermal conductivity, electrical conductivity, and ESD insulation property. For example, in the case of a silicon substrate, a Si₃N₄ layer that has high thermal conductivity and high pressure resistance properties is grown on the silicon substrate, so that the silicon substrate can withstand high voltage drop between the positive electrode and the negative electrode of the module after a plurality of LED tube cores are connected in series; then, a layer of metal electrodes is deposited on the Si₃N₄ layer by masked metal sputtering deposition; next, metal pins are grown on the electrodes.

Moreover, the LED module further comprises an upper cover plate that is designed to change the light emitted from the LED chip units. The upper cover plate essentially form reflection cup disks, and can also be coated with fluorescent powder and provided with micro-lens on the surface, to arrange the light path effectively for the encapsulated module. Wherein, the upper cover plate, epitaxial wafer, and flip-chip bonded substrate shall be designed with scribe lines in a coordinated manner; after the flip-chip bonding between the epitaxial wafer and the packaging substrate is accomplished, the upper cover plate can be bonded with the packaging substrate by wafer-level bonding; then, the bonded assembly can be cut along the scribe lines, to obtain encapsulated LED modules; that process is simple and highly efficient.

It should be appreciated that the above-mentioned LED chip unit structure can also be used in manufacturing of non-flip-chip LED chip units.

In the embodiment of the present invention, LED chip units that respectively contain a plurality of tube cores electrically isolated from each other are used as cutting units of an epitaxial wafer; thus, only scribe lines have to be reserved between the LED chip units, and the electrically isolating area between adjacent tube cores is smaller than the area of scribe line; therefore, the utilization ratio of the epitaxial wafer is greatly improved; since a plurality tube cores are formed integrally, LED chip units are used as basic units and are encapsulated on the substrate in the follow-up encapsulation process; thus, a plurality of tube cores can be encapsulated on the substrate in one operation, and thereby the follow-up encapsulation process is greatly simplified. In addition, matured integrated circuit (IC) technology is applied in the manufacturing process of the LED chip units, and the isolation trenches formed with IC technology reach the precision of wafer-level encapsulation; thus, the utilization ratio of the epitaxial wafer is further improved. Moreover, the epitaxial wafer and packaging substrate are designed with scribe lines in a coordinated manner, the epitaxial wafer and packaging substrate are bonded by flip-chip bonding, and then the assembly is cut, to obtain LED modules. That process is simple and highly efficient.

While the above-mentioned is some preferred embodiments of the present invention, the present invention is not limited to those preferred embodiments. Any modification, equivalent replacement, and improvement made without departing from the spirit and principle of the present invention shall be deemed as falling into the protection scope of the present invention.

### Reference Numeral List

- 1: LED chip unit
- 2: LED tube cours
- 4: scribe line
- 5: isolation trench
- 11: substrate
- 12: first semiconductor layer
- 13: luminous layer
- 14: second semiconductor layer
- 15: epitaxial wafer
- 17: passivation layer
- 18: first semiconductor window
- 21: first electrodes (P-electrodes)
- 22: second electrodes (N-electrodes)
- 31: first pins
- 32: second pins

- S 101: first step
- S 102: second step
- S 103: third step

## Claims

1. A LED chip unit (1), comprising a plurality of LED tube cores (2)that are electrically isolated from each other.

2. The LED chip unit (1) according to claim 1, wherein, adjacent LED tube cores (2) are electrically isolated from each other by an isolation trench (5) that has a bottom surface down to a substrate.

3. The LED chip unit (1) according to claim 2, wherein, the isolation trench (5) is in width not greater than 2µm.

4. The LED chip unit (1) according to claim 1, 2, or 3, wherein electrodes of the tube cores are connected in series or in parallel by means of conductive films.

5. A method for manufacturing the LED chip unit (1) according to claim 1, comprising the following steps:
forming a first semiconductor layer (12), a luminous layer (13), and a second semiconductor layer (14) on a substrate in sequence, to produce an epitaxial wafer (15);
dividing the epitaxial wafer (15) into a plurality of LED chip units (1), and electrically isolating the tube cores (2)from each other in each LED chip unit;
producing electrodes for the LED chip units (1), and performing cutting operation to obtain the LED chip units (1).

6. The method according to claim 5, wherein, an isolation trench (5) that has a bottom surface down to the substrate is formed between adjacent LED tube cores (2) to electrically isolate the adjacent LED tube cores (2).

7. The method according to claim 6, wherein, the isolation trench (5) is formed
- by removing first semiconductor layer (12) partly, luminous layer (13) partly, second semiconductor layer (14) partly, and substrate partly from the epitaxial wafer (15) with integrated circuit (IC) technology.

8. The method according to claim 6 or 7, wherein, the isolation trench (5) is in width not greater than 2µm.

9. The method according to claim 7, wherein, a protective layer is formed on the second semiconductor layer (14), and then a conductive film that is designed to connect the electrodes between the tube cores (2) in the same LED chip unit (1) in series or in parallel is formed on the protective layer.

10. A LED module, comprising the LED chip units (1) according to any of claims 1 to 4 and a packaging substrate that bears the LED chip units (1).

11. The LED module according to claim 10, wherein, the packaging substrate has a circuit pattern that matches the circuit connections in the tube cores (2) of the LED chip units (1).

12. The LED module according to claim 10 or 11, further comprising an upper cover plate designed to change light emitted from the LED chip units (1).

13. A LED lighting apparatus, comprising the LED module according to claim 10, 11, or 12 and a power supply unit that drives the LED module.

14. A LED display apparatus, comprising the LED chip units (14) according to any of claims 1 to 4.
